# EUROPEAN PATENT SPECIFICATION

(11) **EP 0 514 066 B1**
(45) Date of publication and mention of the grant of the patent: **03.01.1996**
(21) Application number: 92304040.6
(22) Date of filing: 05.05.1992
(51) Int. Cl.: H01R 23/72

(54) **Electrical connector with improved retention feature**
Elektrischer Verbinder mit verbessertem Haltemittel
Connecteur électrique avec dispositif de rétention amélioré

(30) Priority: 17.05.1991 US 701929; 17.05.1991 US 703433
(43) Date of publication of application: 19.11.1992
(60) Divisional application: 95200108.9
(73) Proprietor: THE WHITAKER CORPORATION, Wilmington, Delaware 19808 (US)
(72) Inventor: Kile, Richard Allen, Hummelstown, Pennsylvania 17036 (US); Locati, Ronald Peter, Harrisburg, Pennsylvania 17111 (US); Messick, James Harrison, Gastonia, North Carolina 28056 (US); Myers, Leonard Jerry, Kings Mountain, North Carolina 28086 (US)
(74) Representative: Warren, Keith Stanley

(56) References cited:
- DE-A- 1 591 328
- US-A- 3 162 721
- US-A- 4 847 588

## Description

This invention relates to electrical connectors of the type having a connector body and a plurality of posts extending out of one side of the connector body for mounting to a circuit board. In particular, this invention relates to an improved retention feature for such electrical connectors for temporarily holding the electrical connector in place on a printed circuit board prior to soldering.

U.S. Patent 4,847,588 discloses an electrical connector with a retention feature in which the posts of the connector are offset in the form of a crimp to create frictional forces against the side wall of the through hole of the circuit board onto which the electrical connector is mounted. The disclosed retention feature relies entirely on friction, and does not provide any latching force tending to secure the electrical connector in position on the circuit board.

In another type of retention feature for electrical connectors individual pins of the connector are formed to create a latching force against the bottom surface of the circuit board on which the electrical connector is mounted. See for example U.S. Patent 3,524,108 and Japanese UM Publication No. 57-86270. Such below the board retention features can provide an audible click when the connector is seated on the circuit board, and some users regard below the board retention features as more stable.

When below the board retention features are applied to relatively stiff posts such as posts having a cross sectional dimension of 0.0635 by 0.0635 cm (0.025 by 0.025 inches), problems have been encountered. These problems relate to the fact that the through hole geometry of the circuit board varies within a range of tolerances, and the retention feature must function properly throughout this range. In a below the board retention feature the corners of the post latch against the corner of the through hole. In the past, there has been a tendency with relatively thick and inflexible posts for the retention feature to damage the tin plating of the through hole at the corner of engagement with the post, at least when the through hole is near one edge of the tolerance range. This problem has in the past limited the use of below the board retention features with stiff posts.

In the past, posts have been press fit into connector bodies such as pin headers. Pin headers often include either shrouded or shroudless plastic bodies which define preformed through holes into which the posts are press fit for retention in order to form a header assembly. The dimensions of the through holes and the posts are selected such that the corners of the posts interfere with the through holes, thereby retaining the posts in the connector body by a force fit.

In the past, problems have arisen during assembly of posts into such connector bodies. The assembly force required to push a post through a through hole may be undesirably high, and longer posts have experienced buckling due to excessively high assembly forces. Cracking of the plastic body of the connector has also occurred due to large interference forces, which may result in broken shrouds or loose posts. Additionally, plastic material may be skived or driven out of the through hole, accumulating on the tip of the post as it is pushed through the through hole. Such plastic material tends to accumulate on the post tip proper, and can lead to undesirable side effects when soldering the header assembly to a printed circuit board. Poor solder joints have been experienced. The present invention consists in a electrical connector as defined in claim 1. US-A-3 524 108 discloses a connector according to the preamble of claim 1.

According to one aspect of this invention, at least one retention feature is formed on a selected one of the posts of an electrical connector of the type described above. This retention feature comprises a bent portion of the post comprising a first portion extending from the centerline of the post to an apex, and a second portion extending from the apex to the tip, such that the apex is laterally offset from the centerline to a greater extent than is the tip. The post defines two opposed flat faces, and the second portion defines at least one contacting surface positioned to contact the circuit board at the respective corner between the through hole and the surface adjacent the connector body as the post is inserted into the respective through hole. This contacting surface defines a radius of curvature no less than about one fifth of the maximum face to face cross-sectional dimension of the post.

It has been surprisingly discovered that the radiused contacting surface cooperates with the bent portions of the post to provide a below the board retention feature which functions well with a wide range of through hole geometries and without excessive damage to tin plating on the through hole. With this invention, the advantages of below the board retention can be obtained, even with thick and inflexible posts of the type described below.

Embodiments of the present invention will now be described by way of example with reference to the accompanying drawings in which:
FIGURE 1 is a perspective view of a shrouded header assembly which incorporates a presently preferred embodiment of this invention;
FIGURE 2 is a top view of one of the through holes formed in the connector body of Figure 1;
FIGURE 3 is a cross sectional view taken along line 3-3 of Figure 2;
FIGURE 4 is a front view of one of the posts of the connector of Figure 1, mounted in a bandolier prior to insertion into the connector;
FIGURE 5 is an enlarged view of the encircled region 5 of Figure 4;
FIGURE 6 is a cross-sectional view taken along line 6-6 of Figure 4;
FIGURE 7 is a side view taken along line 7-7 of Figure 4;
FIGURE 8 is an enlarged view of the encircled region 8 of Figure 7;
FIGURE 9 is a perspective view of the tip geometry of one of the pins of Figures 5 and 7;
FIGURE 10 is an end view of the tip of the Figure 9 ;
FIGURE 11 is a perspective view of an alternative tip geometry suitable for use with the connector of Figure 1;
FIGURE 12 is an end view of the tip of Figure 11;
FIGURE 13 is an end view showing the configuration of the posts at one of the ends of the connector of Figure 1; and
FIGURE 14 is a cross sectional view showing the posts of Figure 14 engaged with a printed circuit board prior to soldering.

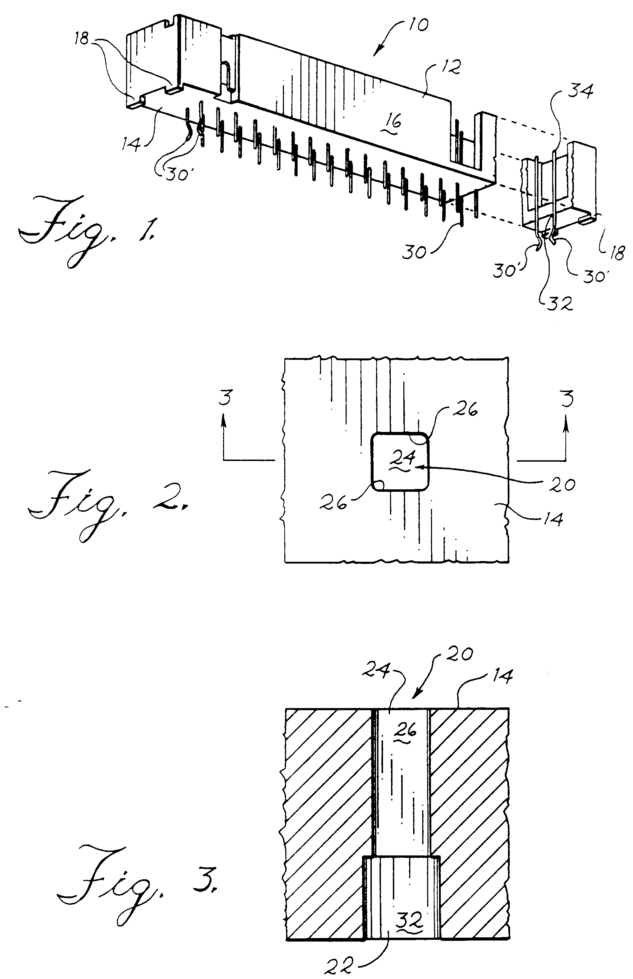

Turning now to the drawings, Figure 1 shows a general view of an electrical connector 10 which incorporates a presently preferred embodiment of this invention. The electrical connector 10 as shown is a header which comprises a connector body 12 molded of a suitable plastic material. The body 12 includes a base 14 and integrally molded side walls 16 and standoffs 18. Rows of through holes are preformed in the base 14 during the molding operation.

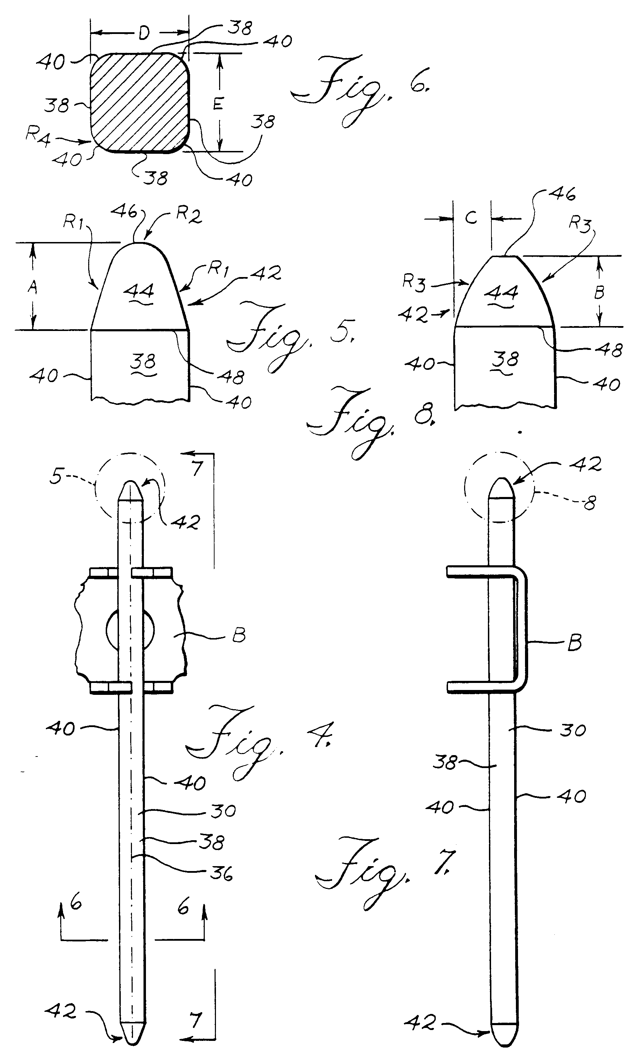

Figures 2 and 3 show further details of one of the through holes 20 of the base 14, which includes a round portion 22 and an out-of-round portion 24 that includes two pairs of opposed faces 26. Preferably, each through hole 20 is formed with a single core pin that forms both the round portion 22 and the out-of-round portion 24, thereby eliminating any internal mating lines (and possible misalignment) within the through hole 20.

As shown in Figure 1, the electrical connector 10 also includes an array of posts 30, 30'. Each of the posts 30, 30' defines a first end 32 and an opposed second end 34. The first ends 32 are adapted to be inserted into through holes of a printed circuit board while the second ends 34 are adapted to mate with a mating connector (not shown). In the connector 10, the four corner posts 30' are provided with a retention feature as described below.

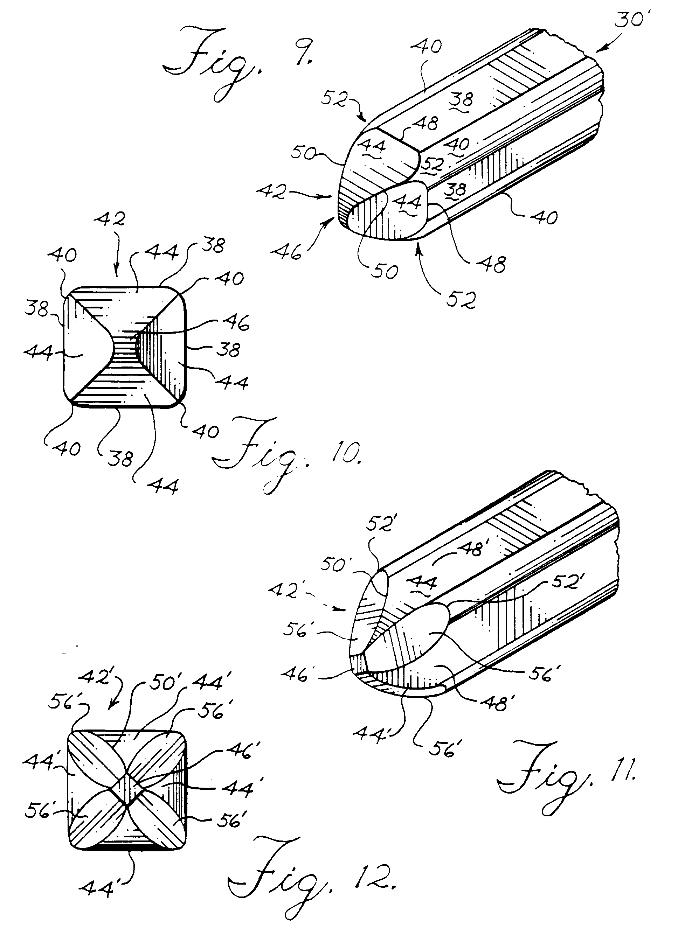

As shown in Figures 4, 6 and 7, each of the posts 30 defines a cross-section which comprises two pairs of opposed post faces 38 that intersect at post edges 40 extending parallel to the centerline 36. As shown in Figure 6, each of the post edges 40 is curved with a radius of curvature which is at least about one fifth of the maximum face to face dimension. In this particular embodiment, the maximum face to face dimension is about 0.0635 cm (0.025 inches) and the radius of curvature is at least about 0.0127 cm (0.005 inches). Figures 4 and 7 show one of the posts 30 mounted in a bandolier B which is used to position and retain the posts 30 for forming, plating and press fit operations in the conventional manner.

Each end of the posts 30, 30' defines a tip 42 which is shaped to provide the advantages described above. The features of the tip 42 described below facilitate insertion of the tip 42 into the through hole 20 and provide improved mating between the mating end and the socket of a mating connector (not shown).

In particular, as shown in Figures 5, 8, 9 and 10, each tip 42 defines four converging tip faces 44 which converge from the body of the post 30 toward a nose 46. The nose 46 may be flat or radiused as desired. In this embodiment each of the tip faces 44 is shaped as a section of a cylinder and is convex outwardly with a radius of curvature that is preferably greater than the maximum face to face dimension of the post 30. Each of the tip faces 44 is aligned with a respective one of the post faces 38 and is joined thereto at a tip-to-body edge 48. Because of the convexity of the tip faces 44, there is a smooth transition between each of the tip faces 44 and the aligned post face 38.

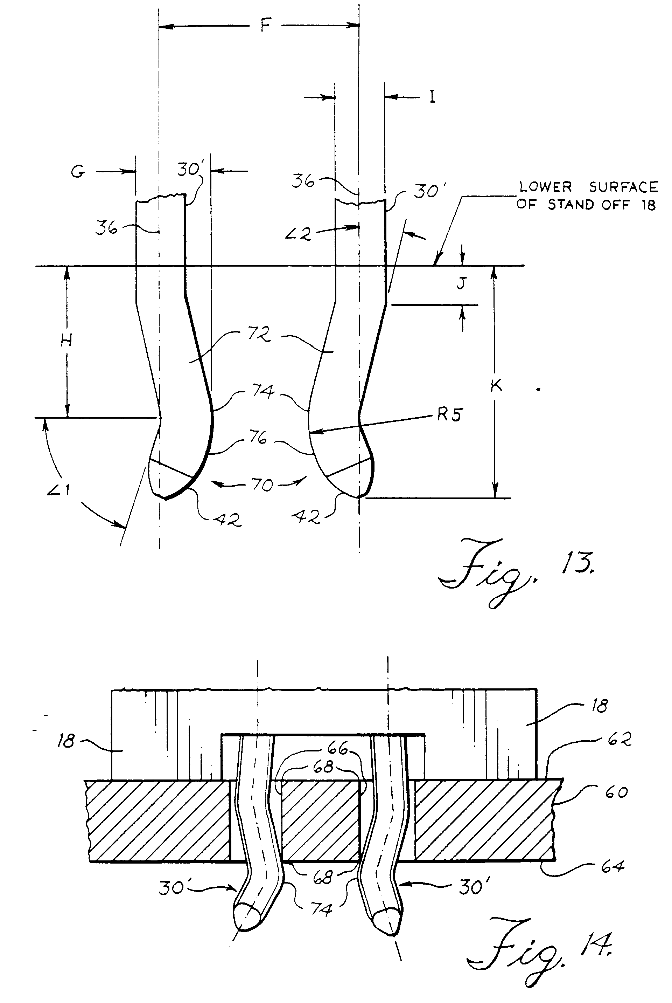

As best shown in Figures 9 and 10, adjacent ones of the tip faces 44 intersect at tip edges 50 which are convex outwardly and which intersect the radiused post edges 40 at tip-to-body corners 52. In this regard, the convexly shaped tip edges 50 cooperate with the radiused post edges 40 to provide a smooth transition and to substantially eliminate protruding corners that might tend to skive the through hole 20 of the body 12 during assembly.

Turning now to Figures 10 and 11, an alternate geometry for the tip 42' includes tip faces 44' substantially as described above which meet at a nose 46'. In this alternate embodiment intermediate surfaces 56' are provided which taper toward the nose 46'. Each of the intermediate surfaces 56' is interposed between two adjacent tip faces 44' such that the intermediate surfaces 56' are rotated by 45 degrees with respect to the tip faces 44'. In this embodiment the tip edges 50' curve inwardly toward the tip faces 44'.

The intermediate surfaces 56' provide a number of advantages. First, they reduce the prominence of the tip-to-body corners 52', thereby reducing skiving problems as described below. Furthermore, because the tip edges 50' curve inwardly toward the tip faces 44', debris tends to be wiped away to the outside of the tip 42' during mating. Furthermore, the shape of the tip faces 44' allows high pressure cleaning of a mating receptacle during mating. In alternative embodiments the tip faces 44' and the intermediate surfaces 56' may be all convex, all planar, or some may be convex and some planar.

In order to assemble the electrical connector 10 the posts 30 are press fit into the through holes 20 of the body 12, by passing the tips 42, 42' through the through holes 20 in a conventional press-fit operation. The tip geometries 42, 42' described above provide advantages during the press-fit operation. Because the tip-to-body corners 52, 52' and the tip-to-body edges 48, 48' are relieved, there is a reduced tendency for the tips 42, 42' to skive plastic out of the body 12 as the tips 42, 42' pass through the through hole 20. Because of the cooperation between the shape of the posts 30 and the shape of the through holes 20, maximum stresses on the body 12 around the through holes 20 are reduced, and maximum insertion forces are reduced as well. Furthermore, because the mating end 54 is shaped as described above, mating forces are reduced as well.

Once the electrical connector 10 has been assembled by press fitting the posts 30 into the body 12, a retention feature can be added to selected ones of the posts 30 to retain the electrical connector 10 temporarily in place in a circuit board prior to soldering. Figure 13 shows an enlarged end view of the connector 10 and two of the corner posts 30'. Figure 14 shows a cross-sectional view of the electrical connector 10 mounted in a circuit board 60 prior to soldering. The circuit board 60 defines top and bottom surfaces 62, 64 and through holes 66 extending therebetween. The through holes 66 are generally cylindrical, and the intersection region between the through holes 66 and the surfaces 62, 64 defines corners 68.

As shown in Figure 13, at least one and preferably pairs of the posts 30' are bent to provide a retention feature 70. The bent portion of each of the posts 30' defines a first portion 72 which diverges away from the centerline 36 to an apex 74. The bent post also defines a second portion 76 which extends from the apex 74 to the tip 42. As shown in Figure 12, the first and second portions 72, 76 are configured such that the apex 74 is positioned to one side of the centerline 36, but the tip 42 is positioned on the centerline 36. The radiused post edges 40 provide rounded contacting surfaces that contact the corners 68 as the retention feature 70 is inserted into the through hole 66. When the connector 10 is installed on the circuit board 60 (Figure 14), the apexes 74 are positioned below the bottom surface 64. In this way, each of the retention features 70 creates a latching force tending to pull the electrical connector 10 into contact with the top surface 62.

Because the retention features 70 function below the board to latch the electrical connector 10 in place, an audible click may be heard when the electrical connector 10 is seated on the circuit board 60. Some users regard this latching type retention feature as more stable than retention features which rely solely on friction within the through hole 66. The retention feature 70 has surprisingly been found to function properly with circuit board through holes 66 having a wide range of diameters, without unacceptable damage to the tin plating that is typically present in the through hole. This surprising result is believed to be directly attributable to the cooperation between the geometry of the first and second portions 72, 76 and the geometry of the radiused post edges 40. The resulting retention feature reduces damage to the through hole plating and functions without any undesirable increase in the length of the post 30' extending below the bottom surface 64 of the circuit board 60.

The retention feature 70 can be used both with straight headers as shown and right angle headers (not shown). Furthermore, the retention feature 70 can be used on single posts or on pairs of posts as shown in which the apex is 74 offset with respect to the centerline 36. Depending upon the application, the apexes 74 may be offset toward one another, away from one another, or at some angle with respect to one another. Furthermore, the retention feature 70 is well suited for use in headers having one, two, or three or more rows of posts 30.

Simply by way of example, the following details of construction have been found suitable in one application. Of course, these details are not intended to limit the scope of this invention, because other applications will often require other specific geometries or materials.

With respect to materials, the posts 30, 30' may be formed from drawn, radiused phosphor bronze wire such as UNS C51000, Temper 3H. The body 12 may be molded of any suitable material such as a glass filled nylon or a liquid crystal polymer.

With respect to dimensions, Table 1 provides presently preferred dimensions, using reference symbols defined in Figures 5, 6, 8 and 13.

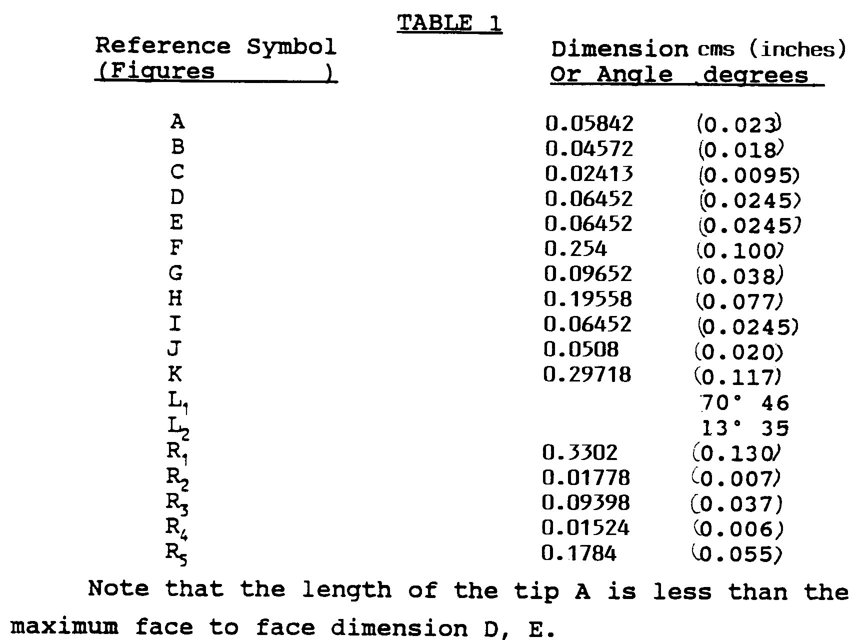

The round portion 22 in this preferred embodiment has a diameter of 0.07036cm (0.0277 inches), and the out-of-round portion 24 in this preferred embodiment defines a maximum diagonal dimension of 0.07036cm (0.0277 inches), and a maximum dimension between opposed faces 26 of 0.05969 cm (0.0235) inches). The posts 30, 30' define a maximum diagonal dimension of 0.074168cm (0.0292 inches). These dimensions have been found to provide excellent post retention without excessive post insertion forces or excessive stresses to the body 12.

Preferably, the tip 42 is formed in a multi-step operation which combines coining and shearing operations, using vertically moving dies. In the first step an upper one of the tip faces 44 is coined downwardly. This pushes excess metal laterally. Then the two side tip faces 44 shown in profile in Figure 5 are sheared into the desired convex shape. Finally, the upper and lower tip faces shown in profile in Figure 8 are coined (the upper tip face for the second time and the lower tip face for the first time) to the final convex shape. This approach provides the desired tip geometry while requiring only dies that move vertically.

The first ends 32 are typically tin plated to facilitate soldering, and the second ends 34 are typically gold plated to facilitate mating operations. However, plating details for the first and second ends do not form part of this invention, and are therefore not described in greater detail here.

This preferred embodiment has been designed for use with through holes 66 having a diameter of 0.1016 cm ± 0.00762 cm (0.040 ± 0.003 inches) in a circuit board 60 having a thickness of 0.15748 cm ± 0.01778 cm (0.062 ± 0.007 inches). Throughout these tolerance ranges the connector 10 can be inserted with an insertion force of no more than 4.54 kg (10 pounds), and adequate retention forces are obtained. Surprisingly, this has been achieved with stiff posts of the type described above, without damage to the tin plating at the corners 68.

The present invention may readily be adapted to square posts of other dimensions and to rectangular posts. Other forming techniques such as rolling and cutting operations may be used to form the tip, and the radiused post edges may be compressively or otherwise formed only in desired regions of the post.

## Claims

1. An electrical connector (10) of the type including a connector body (12) and a plurality of posts (30,30') extending out of one side of the connector body (12) for mounting to a circuit board (60), each of said posts (30,30') defining a tip (42), and a centerline (36), wherein the connector (10) is mounted on a circuit board (60) of the type comprising a pair of spaced, parallel surfaces (62,64) and a plurality of through holes (66) extending therebetween and intersecting the surfaces at corners (68), and wherein each of the posts (30,30') is received in a respective one of the through holes (66), there being at least one retention feature (70), each formed on a selected one of the posts (30,30'), said retention feature (70) comprising a bent portion of the post (30,30') comprising a first portion (72) extending from the centerline (36) to an apex (74), and a second portion (76) extending from the apex (74) to the tip (42), said retention feature (70) being configured such that the apex (74) is situated outside of the respective through hole (66), and the first portion (72) contacts the circuit board (60) at the respective corner between the through hole (66) and the surface opposite the connector body (12);
said second portion (76) defining at least one contacting surface (40) positioned to contact the circuit board (60) at the respective corner (68) between the through hole (66) and the surface adjacent the connector body (12) as the post (30,30') is inserted into the respective through hole (66); characterized in that each of said posts defines two pairs of opposed flat faces (38) and a maximum face to face cross sectional dimension, the second portion (76) extending from the apex (74) to the tip (42) such that the apex (74) is laterally offset from the centerline (36) to a greater extent than is the tip (42),
said contacting surface (40) having a radius (R4) of curvature no less than about one fifth of the maximum face to face cross-sectional dimension of the post.

2. An electrical connector as recited in claim 1, further characterized in that said at least one retention feature comprises at least one pair of retention features (70) and wherein the apexes(74) of the pair are laterally offset in opposite directions with respect to the respective centerlines (36).

3. An electrical connector as recited in Claim 2 further characterized in that the apexes (74) of the pair are laterally offset each toward the other.

4. An electrical connector as recited in Claim 1 further characterized in that the opposed faces in each pair are separated by about 0.0635 cm (0.025 inches) such that the maximum face to face cross-sectional dimension is about 0.0635 cm (0.025 inches).

5. An electrical connector as recited in Claim 4 further characterized in that the radius (R4) of curvature is about 0.01524 cm (0.006 inches).

6. An electrical connector as recited in Claim 5 further characterized in that the tip (42) is positioned on the centerline (36).

7. An electrical connector as recited in Claim 1 further characterized in that the posts (30,30') are stiff.

8. An electrical connector as recited in Claim 1 further characterized in that the post (30, 30') on which the retention feature (70) is formed comprises a drawn wire having four faces that intersect at radiused edges (40), wherein each of the radiused edges (40) defines a radius (R4) of curvature no less than about one fifth of the maximum face to face cross-sectional dimension of the post (30,30').

9. An electrical connector as recited in Claim 8 further characterized in that the tip (42) defines four tip faces(44)which converge toward a tip nose, and wherein each of the tip faces (44) is convex outwardly.

10. An electrical connector as recited in claim 9 further characterized in that the post faces are arranged in opposed pairs separated by about 0.0635 cm (0.025 inches) and wherein the radius edges (40) each define a radius (R4) of curvature no less than about 0.0127 cm (0.005 inches).

## Patentansprüche

1. Elektrischer Verbinder (10) der Art, die einen Verbinderkörper (12) und eine Vielzahl von Stiften (30, 30') aufweist, die sich aus einer Seite des Verbinderkörpers (12) zur Montage an einer Schaltungsplatte (60) erstrecken, wobei jeder der Stifte (30, 30') eine Spitze (42) und eine Mittellinie (36) hat, wobei der Verbinder (10) an einer Schaltungsplatte (60) der Art montiert ist, die ein Paar von beabstandeten parallelen Oberflächen (62, 64) und eine Vielzahl von sich dazwischen erstreckenden Durchgangslöchern (66) aufweist, die die Oberflächen an Ecken (68) durchdringen, und wobei jeder der Stifte (30, 30') in einem entsprechenden der Durchgangslöcher (66) aufgenommen ist, wobei wenigstens ein Haltemittel (70) vorgesehen ist, das jeweils an einem ausgewählten der Stifte (30, 30') ausgebildet ist, wobei das Haltemittel (70) einen gebogenen Abschnitt des Stifts (30, 30') aufweist, der einen ersten Teil (72) hat, der sich von der Mittellinie (36) zu einem Scheitel (74) erstreckt, und einen zweiten Teil (76), der sich von dem Scheitel (74) zu der Spitze (42) erstreckt, wobei das Haltemittel (70) so gestaltet ist, daß der Scheitel (74) außerhalb des entsprechenden Durchgangslochs (66) liegt, und wobei der erste Teil (72) die Schaltungsplatte (60) an der entsprechenden Ecke zwischen dem Durchgangsloch (66) und der Oberfläche entgegengesetzt zu dem Verbinderkörper (12) berührt;
- wobei der zweite Teil (76) wenigstens eine Kontaktoberfläche (40) bildet, die so angeordnet ist, daß sie die Schaltungsplatte (60) an der entsprechenden Ecke (68) zwischen dem Durchgangsloch (66) und der Oberfläche benachbart zu dem Verbinderkörper (12) berührt, wenn der Stift (30, 30') in das entsprechende Durchgangsloch eingesetzt wird,
dadurch**gekenneichnet**, daß jeder der Stifte zwei Paare von entgegengesetzten flachen Flächen (38) und eine maximale Querschnittsdimension von Fläche zu Fläche aufweist, wobei der zweite Teil (76) sich von dem Scheitel (74) zu der Spitze (42) derart erstreckt, daß der Scheitel (74) seitlich gegenüber der Mittellinie (36) um ein größeres Maß versetzt ist als die Spitze (42),
- wobei die Kontaktoberfläche (40) einen Krümmungsradius (R4) hat, der nicht kleiner ist als etwa ein Fünftel der maximalen Querschnittsdimension von Fläche zu Fläche des Stifts.

2. Elektrischer Verbinder nach Anspruch 1, dadurch **gekenneichnet**, daß das wenigstens eine Haltemittel wenigstens ein Paar von Haltemitteln (70) aufweist, wobei die Scheitel (74) des Paares seitlich in entgegengesetzten Richtungen in bezug auf die entsprechenden Mittellinien (36) versetzt sind.

3. Elektrischer Verbinder nach Anspruch 2, dadurch **gekennzeichnet**, daß die Scheitel (74) des Paares seitlich aufeinander zu versetzt sind.

4. Elektrischer Verbinder nach Anspruch 1, dadurch **gekennzeichnet**, daß die entgegengesetzten Flächen in jedem Paar um etwa 0,0635 cm (0,025 Zoll) voneinander beabstandet sind, so daß die maximale Querschnittsdimension von Fläche zu Fläche etwa 0,0635 cm (0,025 Zoll) ist.

5. Elektrischer Verbinder nach Anspruch 4, dadurch **gekennzeichnet**, daß der Krümmungsradius (R4) etwa 0,01524 cm (0,006 Zoll) ist.

6. Elektrischer Verbinder nach Anspruch 5, dadurch **gekennzeichnet**, daß die Spitze (42) auf der Mittellinie (36) angeordnet ist.

7. Elektrischer Verbinder nach Anspruch 1, dadurch **gekennzeichnet**, daß die Stifte (30, 30') steif sind.

8. Elektrischer Verbinder nach Anspruch 1, dadurch **gekennzeichnet**, daß der Stift (30, 30'), an dem das Haltemittel (70) ausgebildet ist, einen gezogenen Draht aufweist, der vier Flächen hat, die sich an abgerundeten Kanten (40) schneiden, wobei jede der abgerundeten Kanten (40) einen Krümmungsradius (R4) bildet, der nicht kleiner ist als etwa ein Fünftel der maximalen Querschnittsdimension von Fläche zu Fläche des Stifts (30, 30').

9. Elektrischer Verbinder nach Anspruch 8, dadurch **gekennzeichnet**, daß die Spitze (42) vier Spitzenflächen (44) bildet, die zu einer Spitzennase hin konvergieren, und wobei jede der Spitzenflächen (44) nach außen konvex ist.

10. Elektrischer Verbinder nach Anspruch 9, dadurch **gekennzeichnet**, daß die Stiftflächen in gegenüberliegenden Paaren angeordnet sind, die um etwa 0,0635 cm (0,025 Zoll) voneinander getrennt sind, und wobei die abgerundeten Kanten (40) jeweils einen Krümmungsradius (R4) von nicht weniger als etwa 0,0127 cm (0,005 Zoll) bilden.

## Revendications

1. Connecteur électrique (10) du type comprenant un corps 12 de connecteur et plusieurs broches (30, 30') faisant saillie vers l'extérieur d'un côté du corps (12) de connecteur pour effectuer un montage sur une plaquette (60) àcircuit, chacune desdites broches (30, 30') définissant une pointe (42), et un axe central (36), le connecteur (10) étant monté sur une plaquette (60) à circuit du type présentant deux surfaces parallèles et espacées (62, 64) entre lesquelles s'étendent plusieurs trous traversants (66) intersectant les surfaces à des angles (68), et chacune des broches (30, 30') étant reçue dans l'un, respectif, des trous traversants (66), au moins un dispositif de retenue (70) étant présent, chaque dispositif étant formé de l'une, choisie, des broches (30, 30'), ledit dispositif (70) de retenue comportant une partie coudée de la broche (30, 30') comprenant une première portion (72) s'étendant depuis l'axe central (36) jusqu'à un sommet (74), et une seconde portion (76) s'étendant du sommet (74) jusqu'à la pointe (42), ledit dispositif (70) de retenue étant configuré de manière que le sommet (74) soit situé à l'extérieur du trou traversant respectif (66), et que la première portion (72) soit en contact avec la plaquette (60) à circuit à l'angle respectif entre le trou traversant (66) et la surface opposée au corps (12) du connecteur ;
ladite seconde portion (76) définissant au moins une surface (40) de contact positionnée pour entrer en contact avec la plaquette (60) à circuit à l'angle respectif (68) entre le trou traversant (66) et la surface adjacente au corps (12) du connecteur lorsque la broche (30, 30') est insérée dans le trou traversant respectif (66) ; caractérisé en ce que chacune desdites broches définit deux paires de faces plates et opposées (38) et une dimension maximale, en section transversale, d'une face à l'autre, la seconde portion (76) s'étendant du sommet (74) jusqu'à la pointe (42) de manière que le sommet (74) soit décalé latéralement de l'axe central (36) davantage que ne l'est la pointe (42),
ladite surface (40) de contact ayant un rayon R₄ de courbure qui n'est pas inférieur à environ un cinquième de la dimension maximale, en section transversale, entre faces de la broche.

2. Connecteur électrique selon la revendication 1, caractérisé en outre en ce que ledit ou chaque dispositif de retenue comprend au moins une paire de dispositifs (70) de retenue, et dans lequel les sommets (74) de la paire sont décalés latéralement dans des directions opposées par rapport aux axes centraux respectifs (36).

3. Connecteur électrique selon la revendication 2, caractérisé en outre en ce que les sommets (74) de la paire sont décalés latéralement l'un vers l'autre.

4. Connecteur électrique selon la revendication 1, caractérisé en outre en ce que les faces opposées de chaque paire sont espacées d'environ 0,0635 cm (0,025 inch) de manière que la dimension maximale en section transversale, entre faces, soit d'environ 0,0635 cm (0,025 inch).

5. Connecteur électrique selon la revendication 4, caractérisé en outre en ce que le rayon R₄ de courbure est d'environ 0,01524 cm (0,006 inch).

6. Connecteur électrique selon la revendication 5, caractérisé en outre en ce que la pointe (42) est positionnée sur l'axe central (36).

7. Connecteur électrique selon la revendication 1, caractérisé en outre en ce que les broches (30, 30') sont rigides.

8. Connecteur électrique selon la revendication 1, caractérisé en outre en ce que la broche (30, 30') sur laquelle est formé le dispositif (70) de retenue comprend un fil étiré ayant quatre faces dont les intersections forment des bords arrondis (40), chacun des bords arrondis (40) définissant un rayon R₄ de courbure qui n'est pas inférieur à environ un cinquième de la dimension maximale, en section transversale, entre faces de la broche (30, 30').

9. Connecteur électrique selon la revendication 8, caractérisé en outre en ce que la pointe (42) définit quatre faces (44) de pointe qui convergent vers un nez de pointe, chacune des faces (44) de pointe étant convexe vers l'extérieur.

10. Connecteur électrique selon la revendication 9, caractérisé en outre en ce que les faces de la broche sont disposées par paires opposées espacées d'environ 0,0635 cm (0,025 inch), et les bords arrondis (40) définissent chacun un rayon R₄ de courbure qui n'est pas inférieur à environ 0,0127 cm (0,005 inch).
